# EUROPEAN PATENT APPLICATION

(11) **EP 0 801 520 A1**
(43) Date of publication of application: **15.10.1997**
(21) Application number: 97302362.5
(22) Date of filing: 07.04.1997
(51) Int. Cl.: H05K 3/34, B41F 15/08

(54) **Method and apparatus for printing solder paste**

(30) Priority: 11.04.1996 JP 89247/96
(71) Applicant: MATSUSHITA ELECTRIC INDUSTRIAL CO., LTD., Kadoma-shi, Osaka-fu, 571 (JP)
(72) Inventor: Taniguchi, Masahiro, Hirakata-shi, Osaka 573 (JP); Mimura, Toshinori, Katano-shi, Osaka 576 (JP); Okanoue, Kazue, Kadoma-shi, Osaka 571 (JP); Onishi, Hiroaki, Higashiosaka-shi, Osaka 578 (JP); Matsumura, Nobuya, Fushimi-ku, Kyoto 612 (JP)
(74) Representative: Rackham, Stephen Neil

(57) **Abstract**

An optimum printed condition of solder paste (4) can be achieved by setting appropriate separating conditions of a screen printing mask (1) and a printed circuit board (2) from each other. Either the printed circuit board (2) or the screen printing mask (1) is moved away from each other upon completion of printing cream solder (4) on a printed circuit board (2), the moving speed of either the printed circuit board (2) or the screen printing mask (1) is switched from a low rate to a high rate when either one reaches a separating position which is just before the screen printing mask (1) and the printed circuit board (2) are completely separated from each other. The separating position is so designated that a maximum amplitude and a duration of a vibration waveform of the screen printing mask (1) being detected by a mask waveform detector (9) are both minimized.

## Description

The present invention relates to a method of and an apparatus for printing a pattern of solder paste onto a printed circuit board.

As electrodes of various electronic components for use in surface-mount technology to produce printed circuit boards have been minimized in size, they are implemented in the form of small lands on the printed circuit boards. For surface-mount technology, the small lands have to be coated with predetermined amounts of solder paste accurately using a high precision printing method.

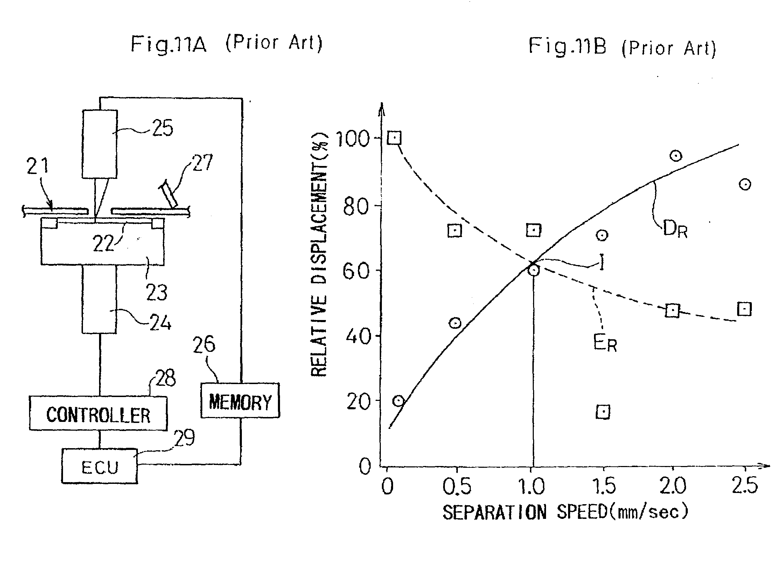

Some of common methods of printing solder paste on the printed circuit boards are hereinafter explained. A method depicted in Japanese Published Unexamined Patent Application 5-111994 (1993) includes printing a pattern of solder paste through a directly placed printing mask 21 on a printed circuit board 22 and lowering the printed circuit board 22 on a stage 23 with a lifting means 24 for separation from the printing mask 21 as illustrated in Fig.11A. In particular, while the maximum values of both deflection D of the printing mask 21 and elongation E of the solder paste applied on the printed circuit board 22 have been measured with a distance sensor 25 during the separation from the printing mask 21 at different speeds and saved in a memory 26, their relative displacements D_{R} and E_{R} to the separating speeds are calculated and plotted. This allows an optimum separating speed of the printed circuit board 22 to be determined by the point I where the curves of the relative displacements D_{R} and E_{R} intersect, as shown in Fig.11B, whereby the pattern of the solder paste will be prevented from being corrupted in shape breaking apart and thus remain in a good printed form. There are also shown in Fig.11A a squeegee 27, a controller 28 for the lifting means, and an electronic control unit (ECU) 29.

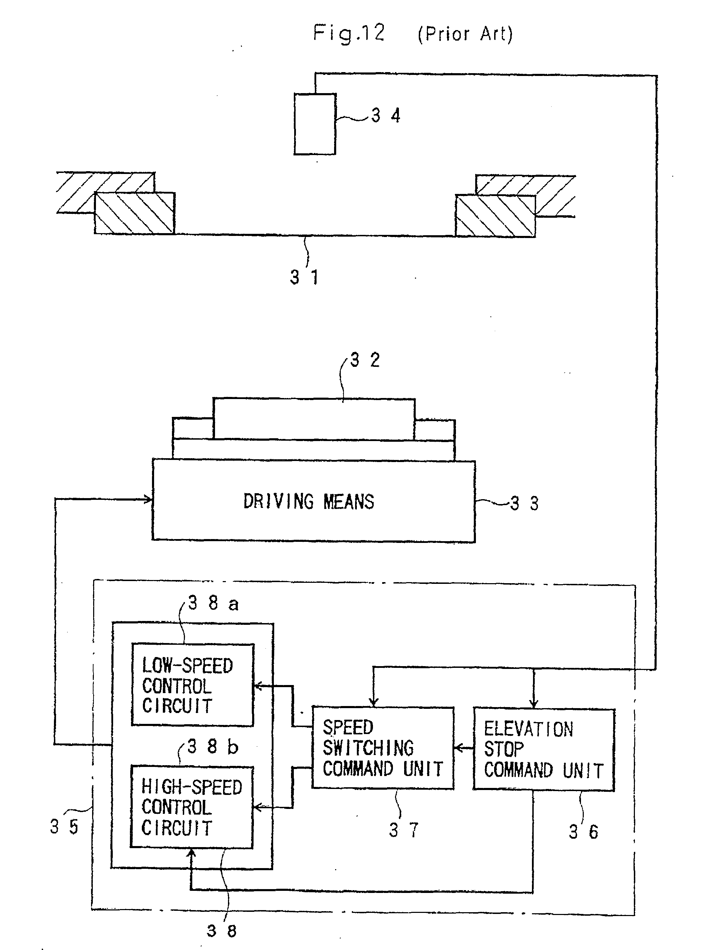

Another method disclosed in Japanese Published Unexamined Patent Application 5-286113 (1993) is provided in which, during the separation of a printed circuit board 32 from a printing mask 31 after completion of a printing process, a downward deflection of the printing mask 31 triggered by the lowering of the printed circuit board 32 with a driving means 33 is detected by a distance sensor 34 as shown in Fig.12. When the downward deflection is shifted to an upward deflection, it is judged that the separation from the printing mask 31 has been completed and the separating speed of the printed circuit board 32 is switched from a lower rate to a higher rate. Illustrated in Fig.12 is a controlling means 35 responsive to a detection signal from the distance sensor 34 for controlling the action of the driving means 33. The controlling means 35 comprises an elevation stop command unit 36, a speed switching command unit 37, and a drive controller 38 which includes a low-speed control circuit 38a and a high-speed control circuit 38b, allowing the printed circuit board 32 on the driving means 33 to be lifted up to a printing position at the higher speed and when printing is completed, lowered down at the lower speed and then at the high speed upon separating from the printing mask 31.

According to the method depicted in the Japanese Published Unexamined Patent Application 5-111994, the separating speed of the printed circuit board 22 is, however, simply defined by values in the vicinity of the intersection between the curves of the relative displacements of the printing mask 21 and the solder paste to the separating speed, and will hardly contribute to the quality of the printed pattern.

In the Japanese Published Unexamined Patent Application 5-286113, it is judged that the separation of the printed circuit board 32 from the printing mask 31 is completed when the downward deflection of the printing mask 31 is turned to an upward deflection and then, the separating speed of the printed circuit board 32 is switched to the higher rate for minimizing time loss. However, this is done only when the separation from the printing mask 31 has been made, i.e., the printing of the solder paste on the printed circuit board 32 has been finished, hence providing no means for improving the quality of solder printing.

For producing a printed pattern of quality, it is essential to control conditions of the separation from a printing mask. If any improper condition is involved, the printed pattern of solder paste may exceed and create blurs and bridges (unwanted connections between neighbor wirings), particularly in its delicate regions, or the printing mask may be fouled with portions of the solder paste, which may lead to shortage of solder paste required to be supplied, causing decline in the quality of printing.

A method of printing a pattern of solder paste on a printed circuit board with the use of a screen printing mask and a squeegee according to the present invention comprises the steps of: moving either the printed circuit board or the screen printing mask at a first separating speed in a direction of separation until either one reaches a separating position which is just before the printed circuit board and the screen printing mask are completely separated from each other after the pattern of the solder paste has been printed; and switching from the first separating speed to a second separating speed which is higher than the first separating speed when either the printed circuit board or the screen printing mask reaches the separating position.

In the switching step, the first separating speed is preferably changed over to the second separating speed at such a separating position that the solder paste between the printed circuit board and the screen printing mask is brittlely fractured.

Also, the second separating speed may be set to be 100 or more times higher than the first separating speed.

The switching step may further comprise the steps of detecting a vibration waveform of the screen printing mask generated after separation of the printed circuit board and the screen printing mask from each other, and determining the separating position to be such that a maximum amplitude of the waveform with respect to a free surface level of the screen printing mask and a vibration duration until the screen printing mask returns to the stationary free surface level are both minimized.

Also, the switching step may further comprise the steps of measuring a profile of the solder paste printed on the printed circuit board, and determining the separation position to be such a point that the height of a burr on the profile of the solder paste relative to the thickness of the printed pattern of the solder paste is minimized.

An apparatus for printing a pattern of solder paste on a printed circuit board with the use of a screen printing mask and a squeegee according to the present invention comprises: a driving system for relatively moving the printed circuit board and the screen printing mask with respect to each other in a direction of separation at a first separating speed and at a second separating speed which is higher than the first separating speed; a controller for controlling the driving system to move either the printed circuit board or the screen printing mask at the first separating speed in the direction of separation until either one reaches a separating position which is just before the printed circuit board and the screen printing mask are completely separated from each other after the pattern of the solder paste has been printed, and to switch from the first separating speed to the second separating speed when either the printed circuit board or the screen printing mask reaches the separating position; a detecting device for detecting a printed condition of the pattern of the solder paste on the printed circuit board; and a designating means for determining a separating position based on detected results of tne detecting device.

The detecting device may be a distance sensor disposed at a distance from the free surface level of the screen printing mask, and the designating means may be so arranged that it detects a vibration waveform of the screen printing mask based on detection signals from the distance sensor for determining the separating position from a maximum amplitude and a duration of the vibration waveform.

The distance sensor may be so arranged to detect the vibration waveform of the screen printing mask generated upon separation of the printed circuit board and the screen printing mask from each other after the pattern of the solder paste has been printed, and the designating means determines the separating position to be such a point that both the maximum amplitude of the vibration waveform with respect to the free surface level of the screen printing mask and the vibration duration until the screen printing mask returns to the stationary free surface level are both minimized.

Also, the detecting device may be so arranged to comprise a detecting sensor for measuring a profile of the pattern of the solder paste printed on the printed circuit board, and a means for detecting a height of a burr on the solder paste from the detected profile of the printed pattern of the solder paste, and the designating means determines the separating position based on detected results of the detecting device.

The designating means may determine the separating position to be such a point that the height of the burr on the solder paste is minimized relative to the thickness of the pattern of the solder paste.

The driving system may drive the printed circuit board to separate from the screen printing mask.

Alternatively, the driving system may drive the screen printing mask to separate from the printed circuit board.

Further, the designating means may determine the separating position, at which the first separating speed is switched to the second separating speed, to be such a point that the solder paste between the printed circuit board and the screen printing mask is brittlely fractured.

The second separating speed of the driving system may be 100 or more times higher than the first separating speed.

According to the method of printing a pattern of solder paste of the present invention, the moving speed of either the screen printing mask or the printed circuit board is shifted from low speed to high speed when either one reaches a separating position which is just before the screen printing mask and the printed circuit board are completely separated from each other, so that the solder paste between the screen printing mask and the printed circuit board is brittlely fractured. This will prevent the solder paste from sticking to the lower surface of the screen printing mask and eliminate unwanted effects such as blurring or smearing, formation of a bridge, and shortage of the solder paste. In order to make the force of separating the solder paste from the mask openings of the screen printing mask smaller than the bonding strength between the solder paste and the printed circuit board, it is necessary to reduce the moving speed of separation between the screen printing mask and the printed circuit board. If the speed remains low during the separation, however, the solder paste between the screen printing mask and the printed circuit board will be ductilely fractured thus producing burrs on the edge thereof and partially remaining on the lower surface of the screen printing mask. The switching of the separating speed to the high speed just before the complete separation will thus cause the solder paste to be brittlely fractured and prevented from developing undesired burrs.

Also, the waveform of a vibration on the screen printing mask which is produced upon the separation of the screen printing mask and the printed circuit board from each other is detected and used for determining a separating position. If the separating speed is switched to the high speed when most of the solder paste remains in the mask openings of the screen printing mask, the vibration of the screen printing mask increases in both the amplitude and the duration. If the separation speed is maintained to be low until the completion of separation, the vibration greatly increases. By determining a separating position to be such a point that both the amplitude and the duration of the vibration are minimized, the development of burrs on the solder paste will be prevented.

Similarly, the development of burrs on the solder paste will be avoided by designating the separating position to such a point that the height of a specific burr relative to the thickness of the printed pattern of the solder paste is minimized.

The apparatus for printing a pattern of solder paste according to the present invention will thus achieve the aim of printing a pattern of solder paste in a favourable form by the method of determining an optimum separating position through detecting the waveform of a vibration on the screen printing mask or the profile of a burr on the solder paste relative to the thickness of the solder paste pattern.

Specific embodiments of the apparatus suitable for use in this invention are shown in the drawings wherein:
Fig. 1 is a schematic view of an apparatus for printing a pattern of solder paste showing one embodiment of the present invention;
Fig. 2 is a cross sectional view showing a mask opening filled with solder paste according to the embodiment;
Figs. 3A-3E are explanatory views showing steps of separating a screen printing mask and a printed circuit board from each other according to the embodiment;
Fig. 4 is a diagram explaining a movement of the screen printing mask in the separating action;
Fig. 5 is a diagram explaining a movement of the screen printing mask when the separating position is different from that shown in Fig.4;
Fig. 6 is a diagram explaining a movement of the screen printing mask when the separating position is different from that shown in Fig.4;
Fig. 7 is an explanatory view showing a profile of the solder paste which has been printed;
Fig. 8 is a graphic diagram showing the relation between the separating position and the height of a burr according to another embodiment of the present invention;
Fig. 9 is a schematic view of an apparatus for printing a pattern of solder paste showing a further embodiment of the present invention;
Fig. 10 is a schematic view of an apparatus for printing a pattern of solder paste showing a still further embodiment of the present invention;
Fig. 11A is a schematic view showing a conventional method of printing a pattern of solder paste;
Fig. 11B is a diagram showing the relation between the relative displacement of a printing mask and the separating speed in the conventional method; and
Fig. 12 is a schematic view explaining another conventional method of printing a pattern of solder paste.

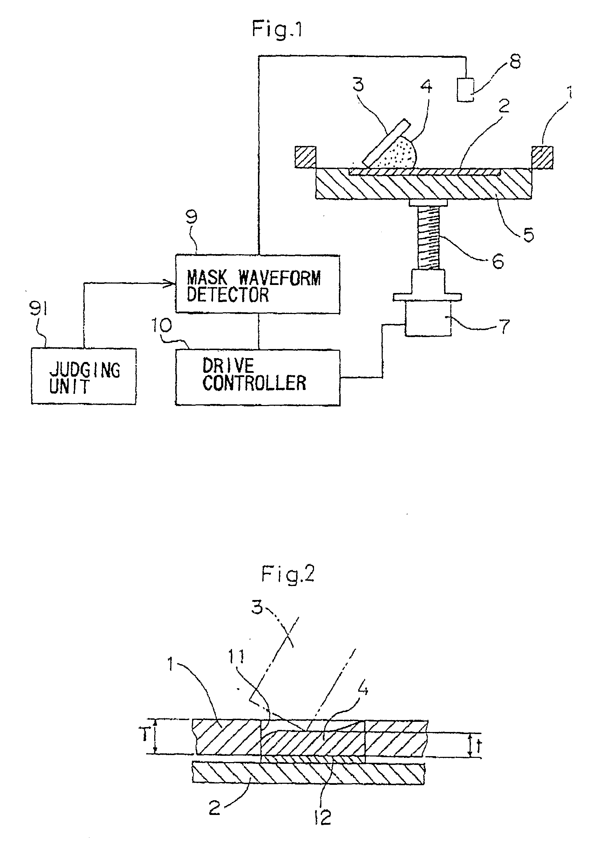

One embodiment of the apparatus of printing a pattern of solder paste according to the present invention will be described referring to Fig.1 to 4.

Illustrated in Fig.1 are a screen printing mask 1, a printed circuit board 2, a squeegee 3, a solder paste 4, a stage 5 supporting the printed circuit board 2 for vertical movements, an vertical movement mechanism 6 which may comprise a ballscrew and a nut, and a driving means 7 for driving the vertical movement mechanism 6 with a motor rotating the nut forward and backward to vertically move the ballscrew. A distance sensor 8 is disposed at a proper distance from and above the screen printing mask 1 for measuring a displacement of the screen printing mask 1 which is then used in a mask waveform detector 9 for detecting the waveform of a vibration of the screen printing mask 1. The resultant vibration waveform is transmitted to a drive controller 10 for controlling the action of the driving means 7.

The operation of the apparatus for printing a pattern of solder paste according to the first embodiment will now be explained. The printed circuit board 2 is lifted up by the stage 5 and brought to direct contact with the screen printing mask 1. Solder paste 4 is then supplied onto the screen printing mask 1 and spread out with the squeegee 3 to fill openings 11 in the screen printing as 1 (hereinafter referred to as mask openings). When the squeegee 3 is made of a soft, resilient material such as urethane rubber, it runs deep in the mask openings 11 due to its resiliency and removes portions of the solder paste 4 so that the thickness (t) of the filled solder paste 4 in cross section is smaller than the thickness (T) of the screen printing mask 1, as shown in Fig.2. Denoted as 12 in Fig.2 is a land of copper foil of the printed circuit board 2.

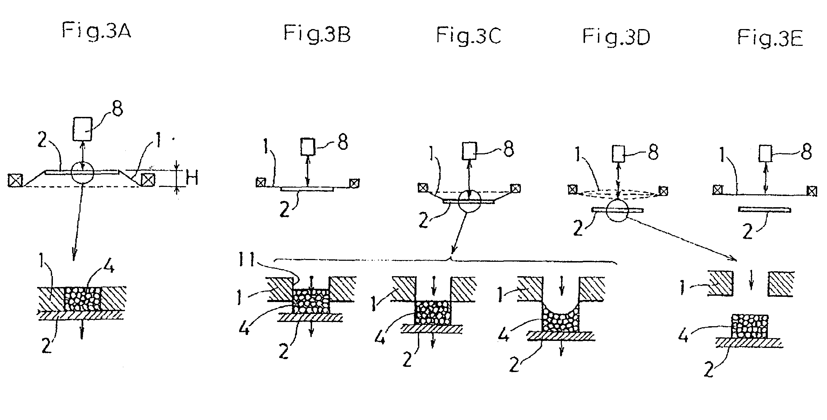

The printing of the solder paste 4 is followed by the step of separating the printed circuit board 2 from the screen printing mask 1. Fig.3 illustrates behaviors of the solder paste 4 filled in the mask openings 11 of the screen printing mask 1 during the separation. When the printed circuit board 2 has been printed with the pattern of the solder paste 4 in Fig.3A, it is lifted down at a predetermined speed with the screen printing mask 1 being deflected from its free surface level until the solder paste 4 is about to separate from the screen printing mask 1, as shown in Figs.3B, and 3C. In the steps shown in Fig.s 3B and 3C, the solder paste 4 printed on the printed circuit board 2 gradually separates from the screen printing mask 1 as moving out from the mask openings 11 of the same. The separation of the solder paste 4 from the screen printing mask 1 causes the screen printing mask l to vibrate due to the resiliency as shown in Fig.3D, before returning to a stationary state at its free surface level as shown in Fig.3E. The printed circuit board 2 is further lowered to an initial transfer position. The speed of lowering the printed circuit board 2, especially during the steps shown in Fig. 3B and 3C will determine the quality of printing the pattern of the solder paste 4 on the printed circuit board 2.

More specifically, it is essential that the bonding strength of the solder paste 4 to the printed circuit board 2 is greater than the force required for removing off the solder paste 4 from the mask openings 11 in order for transferring the pattern of solder paste 4 filled in the mask openings il of the screen printing mask 1 to the printed circuit board 2. If the solder paste 4 is of such a high viscosity type as having a thixotropic property, its strength of sticking to the walls of the mask openings 11 is increased and it may remain in the mask openings 11 when its bonding strength to the printed circuit board 2 is insufficient. It was found through a series of experiments that the speed of separating the printed circuit board 2 from the screen printing mask 1 of 150 micrometers in thickness should be around 0.1 mm/sec. The optimum separating speed may vary depending on the viscosity of the solder paste 4.

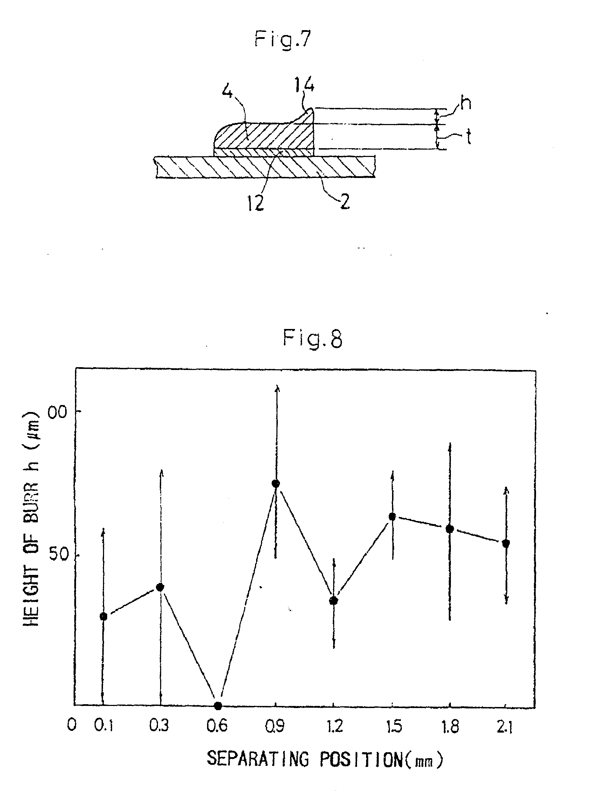

If the speed of separating the printed circuit board 2 from the screen printing mask 1 is kept at such low speed (e.g. 0.1 mm/sec) all through the process of separation, a printed pattern of the solder paste 4 of high quality cannot always be attained on the printed circuit board 2. This is because it is inevitable that the solder paste 4 upon separating from the screen printing mask 1 is ductilely fractured hence producing burrs 14 at the edge as shown in Fig. 7. The ductile fracture creates-burrs on the edge of the pattern of the solder paste 4 and also allows portions of the solder paste 4 to remain stuck to the lower side of the screen printing mask 1. The remaining solder paste 4 on the screen printing mask 1 will cause smearing in the succeeding printing action. For avoiding the above adverse effect, the solder paste 4 should be brittlely fractured upon the printed circuit board 2 separating from the screen printing mask 1. This is accomplished by increasing the separation speed of the screen printing mask 1 and the printed circuit board 2 at a certain point and briskly bringing the solder paste 4 and the mask openings 11 apart, rather than by maintaining a constant low speed during the separation of the printed circuit board 2 from the screen printing mask 1. It was found through che experiments that the increased speed is preferably as high as 20 mm/sec. More particularly, it is desired to increase the speed of separating or lifting down the printed circuit board 2 to at least a 100 times higher rate so as to assuringly cause the solder paste 4 to be brittlely fractured. For example, the speed is preferably switched from 0.1 mm/sec to 20 mm/sec.

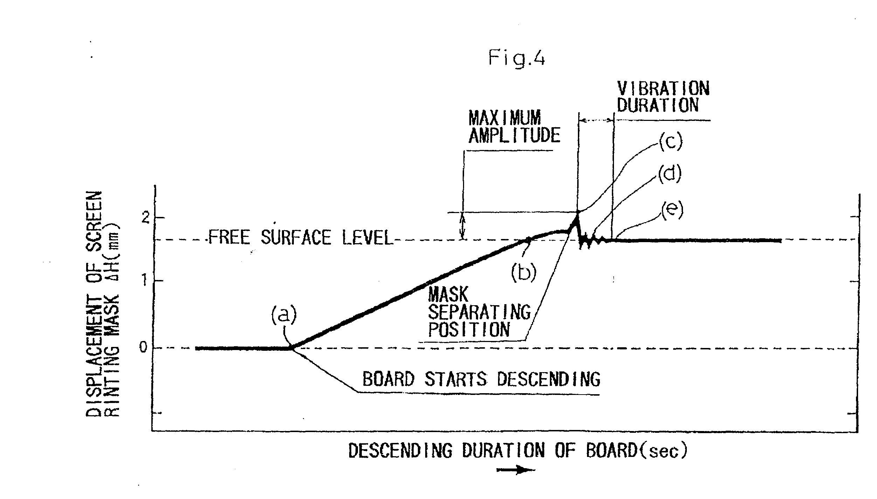

The determining an optimum position (referred to as a mask separating position hereinafter in this description) where the separating speed is to be switched will now be explained referring to Fig. 4. Fig.4 is a diagram showing the displacement of the screen printing mask 1 during the separation of the printed circuit board 2, in which the horizontal axis represents the descending duration of the printed circuit board 2 and the vertical axis is the displacement ΔH of a central part of the screen printing mask 1 from the free surface level. The points (a) to (e) shown in Fig.4 correspond to the steps shown in Figs.3A to 3E, respectively. The part for measuring vibration of the screen printing mask 1 is not limited to the central part, although it is preferable as the screen mask vibrates most at its center.

As the step proceeds from the point (b) to the point (c) in Fig.4, the switching of the separating speed from low speed to high speed with most of the solder paste 4 remaining in the mask openings 11 greatly increases the amplitude and duration of the vibration of the screen printing mask 1. When the timing of the speed switching is delayed, i.e., the duration of lowering the printed circuit board 2 at low speed is extended, the amplitude and duration of the vibration will keep decreasing, until the point when the solder paste 4 is completely separated from the mask openings 11, where both the amplitude and duration of the vibration become greater.

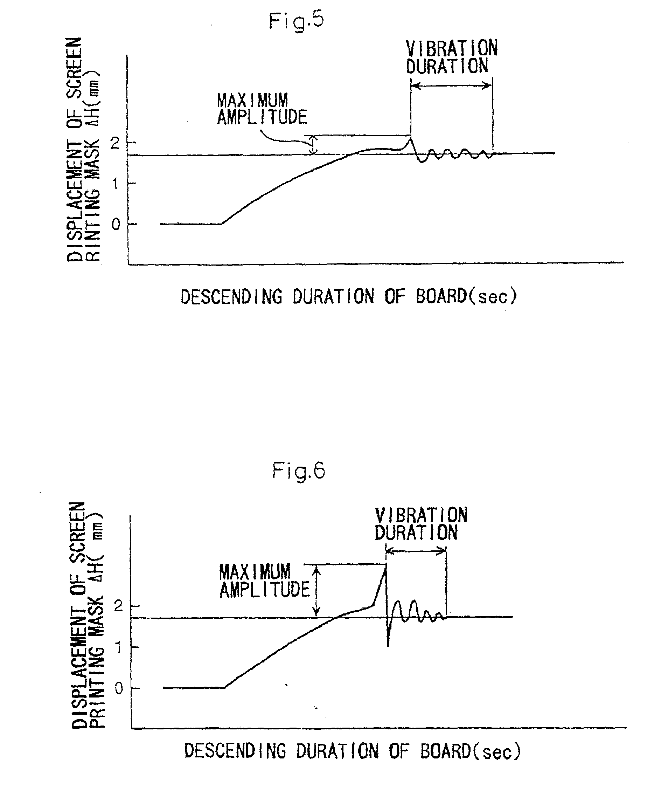

For example, when the separating speed is maintained at 0.1 mm/sec after the printed circuit board 2 passed an optimum separating position, the duration of the vibration will increase while the amplitude is diminished, as shown in Fig.5. If the separating speed is switched from the low speed (e.g. 0.1 mm/sec) to the high speed (e.g. 20 mm/sec) before the printed circuit board 2 reaches the optimum separating position, the amplitude of the vibration will increase although the duration is minimized as shown in Fig.6.

It is thus essential to switch the speed of separating the printed circuit board 2 from the screen printing mask I from the low speed to the high speed at the optimum separating position between the points (b) and (c) shown in Fig.4 or just before the separation is physically completed in order for minimizing both the amplitude and the duration of the vibration and for eliminating the burrs 14 on the solder paste 4. More particularly, the optimum separating position falls between the point (b) where the waveform of the vibration intersects the free surface level of the screen printing mask 1 and the point (c) where the amplitude of the vibration is peaked, and may preferably be designated to the front end of a rise before the peak of the amplitude. The method disclosed in Japanese Published unexamined Patent Application 5-286113, in which the speed is switched when the displacement of the printing mask is shifted from downward to upward, will thus create the foregoing drawback, since the point where the displacement changes from downard to upward means the point (c) where the separation has bee completed. In the embodiment of the present invention, the separating speed may be set to any given rate, e.g. 0.1 or 20 mm/sec, from the point (a) to the point (b), but be preferably kept as low as 0.1 mm/sec between the point (b) and the separating position, and as high as 20 mm/sec after the separating point.

In this embodiment, to determine the separating position, the displacement of the screen printing mask 1 is measured by the distance sensor 8 with the separating speed being switched from a low rate to a high rate at various points, the vibration waveform is examined by the mask waveform detector 9 to calculate the relation between the amplitude and duration of the vibration of the screen printing mask 1 and the speed switching position. Then, the separating position is designated to such a point that the amplitude and duration of the vibration are minimized. It is also possible to have an equal effect by changing the separating speed in lieu of the separating position.

As the speed of separating the printed circuit board 2 from the screen printing mask 1 is switched by the drive controller 10 from the low speed to the high speed at the optimum separating position, the solder paste 4 between the screen printing mask 1 and the printed circuit board 2 will be brittlely fractured and thus prevented from sticking to the lower side of the screen printing mask 1 and from causing smearing problems at the succeeding steps so that its printed pattern is clearly defined.

Although the detection of a vibration waveform of the screen printing mask 1 and the setting and change of the separating position are carried out all by the mask waveform detector 9 in the above described embodiment, they may be implemented to be carried out by their respective means.

A judging unit 91 for examining whether or not the pattern of the solder paste 4 is printed correctly may be further provided as shown in Fig.1. If the judging unit 91 judges that the quality of the printed pattern of the solder paste 4 is not within a range of acceptable level, the mask waveform detector 9 is actuated to change the separating position. The acceptable level range permits the pattern of the solder paste 4 to have no direct contact or bridge between any two adjacent portions and may be determined through a series of experiments depending on applicable conditions and changed if desired or needed.

Although it has been described how the separating position of the printed circuit board 2 is determined through detecting and analyzing the waveform of a vibration of the screen printing mask 1 in this embodiment, it is not limited to this method to determine the separating position. For example, the height h of a burr 14 on the edge of the solder paste 4, shown in Fig.7, which is produced when the separating position is not adequate, may be measured as shown in Fig.8 with the timing of switching the separating speed from the low speed to the high speed being varied. The optimum separating position of the printed circuit board 2 is designated to such a point that the height h of the burr is minimum. Referring to Fig.8, the separating position is expressed as a distance front the free surface level of the screen printing mask 1.

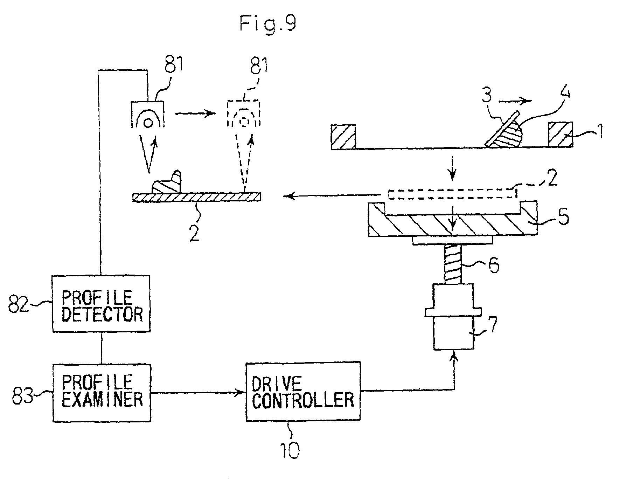

Fig.9 illustrates a procedure of measuring the height of a burr 14 according to another embodiment of the present invention. When the pattern of the solder paste 4 has been printed, the printed circuit board 2 is taken out from the stage 5 and loaded at burr measuring position denoted by a solid line. A laser emitter/receiver 81 emits a laser beam to the printed circuit board 2 and receives its reflection to measure a cross sectional figure of the pattern of the solder paste 4 printed on the printed circuit board 2. Preferably, the laser beam is scanned over the printed circuit board 2 in the same direction as the movement of the squeegee 3. The scanning of the laser beam is made so that at least one profile data is obtained from each segment of the solder paste 4 on the printed circuit board 2. The profile data is saved in a profile detector 82 and examined by a profile examiner 83. If the height of a burr found from the profile data of the profile detector 82 is higher than a predetermined acceptable level, the profile examiner 83 commands the drive controller 10 to change the separating position of the printed circuit board 2 and drive the driving means 7 so that the lowering speed of the stage 5 is switched from the low speed to the high speed at the newly determined separating position.

Although the examination of the profile data and the change of the separating position are carried out all by the profile examiner 83 in the above described embodiment, they may be implemented to be carried out by their respective means. The acceptable height level of the burr is within the range where the burr stays away from any neighbor land of the solder paste when it is outwardly folded down and causes no direct contact or bridge between the two adjacent lands, and may be determined through a series of experiments and changed if desired or needed.

The separating position of the printed circuit board 2 from the screen printing mask 1 is determined by either measuring the profile of a burr *as* shown in Fig.9 or detecting the waveform of a vibration as shown in Fig.1. It is also possible to set the separating position to an intermediate between the point determined from the burr profile data and the point determined from the vibration waveform data. If there are a plurality of burrs on the solder paste 4, the optimum separating position may be obtained by examining the profiles of the burrs to estimate a group of the separating positions and averaging the separating positions to determine an optimum separating position.

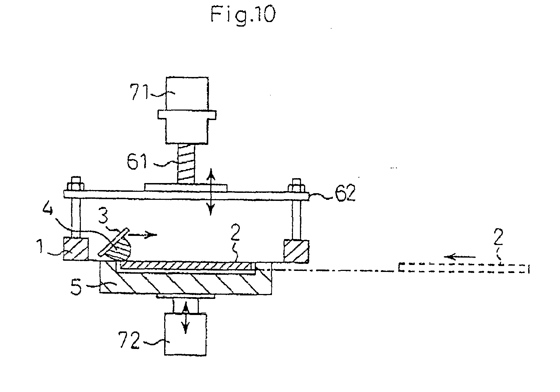

The separation of the printed circuit board 2 from the screen printing mask 1 after printing the pattern of the solder paste in the above described embodiment is implemented by causing the driving means 7 to lifting down the stage 5 with the printed circuit board 2 loaded on but not the screen printing mask 1. Any other appropriate methods may also be employed with equal success, for example, where the screen printing mask 1 is upwardly brought apart from the printed circuit board 2 by a driving means 71 as shown in FLg.10. Referring to Fig. 10, the screen printing mask 1 is joined by a bracket 62 to a ballscrew 61 which serves as the lifting mechanism. The ballscrew 61 is driven by an actuating means or a motor 71 for rotation. The stage 5 supporting the printed circuit board 2 is lifted up and down by a stage lifting cylinder 72 for loading and unloading the printed circuit board 2 on the printing position. In action, the screen printing mask 1 after the printing of a pattern of solder paste is completed is lifted up by the rotation of the motor 71 at a low speed from the printed circuit board 2. When the screen printing mask 1 reaches the separating position in relation to the printed circuit board 2, the rotation of the motor 71 is switched from low speed to high speed to give the same effect as of the previously described embodiment in the separation of the screen printing mask I from the printed circuit board 2.

According to the method of printing a pattern of solder paste of the present invention, as can be seen from the above, the separating speed of either the printed circuit board or the screen printing mask is switched from a low rate to a high rate upon reaching a separating position which is just before the printed circuit board and the screen printing mask are completely separated from each other. This causes the solder paste between the printed circuit board and the screen printing mask prior to the separation to be brittlely fractured and thus prevented from sticking to the lower side of the screen printing mask. Accordingly, the pattern of the solder paste is printed down in a favorable condition while unwanted incidents such as blurring or smearing, bridge forming, and shortage of the solder paste will be eliminated.

Also, the waveform of a vibration on the screen printing mask which is produced upon the separation of the screen printing mask and the printed circuit board from each other is detected and used for determining a separating position where the amplitude and the duration of the vibration are minimized. As a result, the separation between the screen printing mask and the printed circuit board will be carried out at the best condition hence permitting the pattern of the solder paste to be printed desirably.

Furthermore, the profile of the solder paste printed on the printed circuit board is directly measured to examine the size of a burr and the optimum separating position is designated to be such a point that the height of the burr is minimized relative to the thickness of the solder pate pattern. Accordingly, the screen printing mask will be separated at an optimum separating position thus leaving the favorable pattern of the solder paste.

According to the method and apparatus for printing a pattern of solder paste, the solder paste can be printed in a desired form by determining an optimum separating position through detecting and analyzing the waveform of a vibration on the screen printing mask or the profile of a burr on the solder paste relative to the thickness of the solder paste pattern.

## Claims

1. A method of printing a pattern of solder paste (4) on a printed circuit board (2) with the use of a screen printing mask (1) and a squeegee (3), comprising the steps of:
moving either the printed circuit board (2) or the screen printing mask (1) at a first separating speed in a direction of separation until either one reaches a separating position which is just before the printed circuit board (2) and the screen printing mask (1) are completely separated from each other after the pattern of the solder paste (4) has been printed; and
switching from the first separating speed to a second separating speed which is higher than the first separating speed when either the printed circuit board (2) or the screen printing mask (1) reaches the separating position.

2. A method of printing a pattern of solder paste(4) according to claim 1, wherein the first separating speed is changed over to the second separating speed in the switching step at such a separating position that the solder paste (4) between the printed circuit board (2) and the screen printing mask (1) is brittlely fractured.

3. A method of printing a pattern of solder paste (4) according to claim 1 or 2, wherein the second separating speed is 100 or more times higher than the first separating speed.

4. A method of printing a pastern of solder paste (4) according to any of claims 1 to 3, wherein the switching step further comprises the steps of detecting a vibration waveform of the screen printing mask (1) generated after separation of the printed circuit board (2) and the screen printing mask (1) from each other, and determining the separating position to be such that a maximum amplitude of the waveform with respect to a free surface level of the screen printing mask (1) and a vibration duration until the screen printing mask (1) returns to the stationary free surface level are both minimized.

5. A method of printing a pattern of solder paste (4) according to any of claims 1 to 4, wherein the switching step further comprises the steps of measuring a profile of the solder paste (4) printed on the printed circuit board (2), and determining the separating position to be such a point that a height of a burr (14) on the profile of the solder paste (4) relative to a thickness of the printed pattern of the solder paste (4) is minimized.

6. An apparatus for printing a pattern of solder paste (4) on a printed circuit board (2) with the use of a screen printing mask (1) and a squeegee (3), comprising:
a driving system (7) for relatively moving the printed circuit board (2) and the screen printing mask (1) with respect to each other in a direction of separation at a first separating speed and at a second separating speed which is higher than the first separating speed;
a controller (10) for controlling the driving system (7) to relatively move the printed circuit board (2) and the screen printing mask (1) at the first separating speed in the direction of separation until either one reaches a separating position which is just before the printed circuit board (2) and the screen printing mask (1) are completely separated from each other after the pattern of the solder paste (4) has been printed, and to switch from the first separating speed to the second separating speed when either the printed circuit board (2) or the screen printing mask (1) reaches the separating position;
a detecting device for detecting a printed condition of the pattern of the solder paste (4) on the printed circuit board (2); and
a designating means (9) for determining a separating position based on detected results of the detecting device.

7. An apparatus for printing a pattern of solder paste (4) according to claim 6, wherein the detecting device is a distance sensor (8) disposed at a distance from the free surface level of the screen printing mask (1), and the designating means (9) detects a vibration waveform of the screen printing mask (1) based on detection signals from the distance sensor (8) for determining the separating position from a maximum amplitude and a duration of the vibration waveform.

8. An apparatus for printing a pattern of solder paste (4) according to claim 7, wherein the distance sensor (8) detects the vibration waveform of the screen printing mask (1) generated upon separation of the printed circuit board (2) and the screen printing mask (1) from each other after the pattern of the solder paste (4) has been printed, and the designating means (9) determines the separating position to be such a point that the maximum amplitude of the waveform with respect to a free surface level of the screen printing mask (1) and the vibration duration until the screen printing mask (1) returns to the stationary free surface level are both minimized.

9. An apparatus for printing a pattern of solder paste (4) according to claim 6, wherein the detecting device comprises a detecting sensor (81) for measuring a profile of the pattern of the solder paste (4) printed on the printed circuit board (2), and a means (82) for detecting a height of a burr (14) on the solder paste (4) from the detected profile of the printed pattern of the solder paste (4), and a designating means (83) determines the separating position based on detected results of the detecting device.

10. An apparatus for printing a pattern of solder paste (4) according to claim, 9, wherein the designating means (83) determines the separating position to be such a point that the height of the burr (14) on the solder paste (4) is minimized relative to a thickness of the pattern of the solder paste (4).

11. An apparatus for printing a pattern of solder paste (4) according to any of claims 6 to 10, wherein the driving system (7) drives the printed circuit board (2) to separate from the screen printing mask (1).

12. An apparatuse for printing a pattern of solder paste (4) according to any of claims 6 to 10, wherein the driving system (7) drives the screen printing mask (1) to separate from the printed circuit board (2).

13. An apparatus for printing a pattern of solder paste (4) according to any of claims 6 to 12, wherein the designating means determines the separating position, at which the first separating speed is switched to the second separating speed, to be such a point that the solder paste (4) between the printed circuit board (2) and the screen printing mask (1) is brittlely fractured.

14. An apparatus for printing a pattern of solder paste (4) according to any of claims 6 to 13, wherein the second separating speed of the driving system (7) is 100 or more times higher than the first separating speed.
